# EUROPEAN PATENT APPLICATION

(11) **EP 4 064 561 A1**
(43) Date of publication of application: **28.09.2022**
(21) Application number: 20875951.4
(22) Date of filing: 21.02.2020
(51) Int. Cl.: H03H 9/02, H03H 9/17, H03H 9/56

(54) **BULK ACOUSTIC RESONATOR PROVIDED WITH NON-CONDUCTIVE INSERTION LAYER, FILTER, AND ELECTRONIC DEVICE**

(30) Priority: 18.10.2019 CN 201910994460
(71) Applicant: Tianjin University, Tianjin 300072 (CN); Rofs Microsystem (Tianjin) Co., Ltd, Tianjin 300462 (CN)
(72) Inventor: ZHANG, Menglun, Tianjin 300072 (CN); PANG, Wei, Tianjin 300072 (CN); YANG, Qingrui, Tianjin 300072 (CN)
(74) Representative: Meyer-Dulheuer MD Legal Patentanwälte PartG mbB
(86) International application number: PCT/CN2020/076226
(87) International publication number: WO 2021/073022

(57) **Abstract**

A bulk acoustic resonator, which includes: a substrate; an acoustic lens (18); a bottom electrode (10); a top electrode (12); and a piezoelectric layer (11). An edge part of the top electrode (12) is provided with a gap part, a gap is present between the gap part and the piezoelectric layer (11) in the thickness direction of the resonator, and a non-conductive insertion layer (13) is provided in at least a part of the gap. The present disclosure further relates to a filter and an electronic device.

## Description

### TECHNICAL FIELD

Embodiments of the present disclosure relate to the field of semiconductors, and in particular, to a bulk acoustic wave resonator, a filter, and an electronic device having one of the above components.

### BACKGROUND

A film bulk acoustic resonator (FBAR, also referred to as Bulk Acoustic Wave Resonator, BAW), as an important member of the piezoelectric devices, is important in the field of communications. In particular, FBAR filters have an increasing market in the field of radio frequency (RF) filters. The FBAR has excellent characteristics such as small size (µm level), high resonant frequency (GHz), high quality factor (100), large power capacity, and good roll-off effect. The filters of FBAR are gradually replacing traditional surface acoustic wave (SAW) filters and ceramic filters. The filters of FBAR play a huge role in the field of wireless communication radio frequency, and the high sensitivity advantage thereof can be applied to biological, physical, medical and other sensing fields.

The structural main body of the film bulk acoustic wave resonator is a "sandwich" structure composed of electrode-piezoelectric film-electrode, that is, a piezoelectric material is sandwiched between two metal electrode layers. By inputting a sinusoidal signal between the two electrodes, the FBAR converts the input electrical signal into mechanical resonance by the inverse piezoelectric effect, and converts the mechanical resonance into an electrical signal for output by the piezoelectric effect. The film bulk acoustic resonator generates the piezoelectric effect by mainly using a longitudinal piezoelectric coefficient (d33) of a piezoelectric film, so that its main working mode is a thickness extensional mode (TE mode) in a thickness direction.

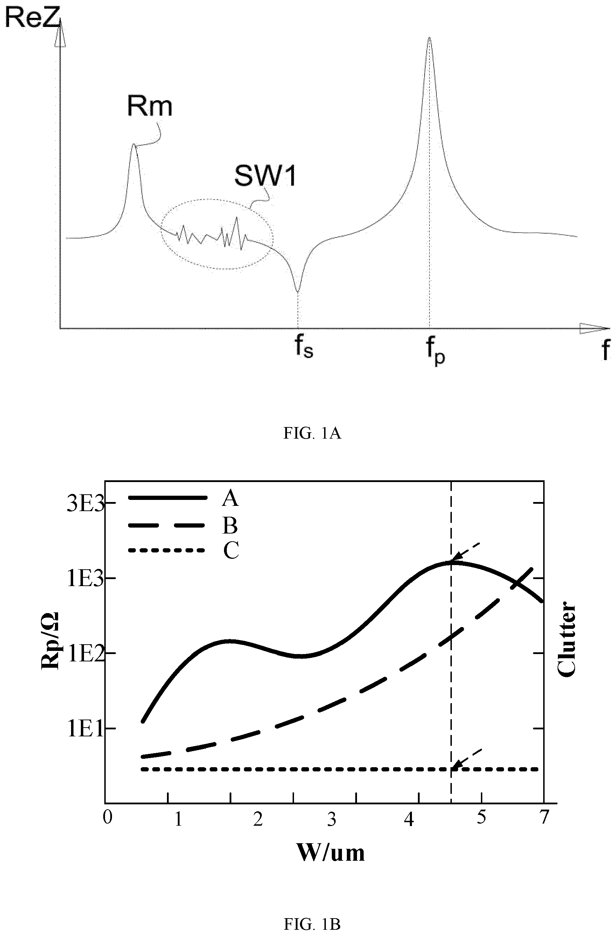

Ideally, the film bulk acoustic resonator only excites the thickness extensional mode (TE mode). However, in addition to the desired TE mode, the film bulk acoustic resonator also generates lateral parasitic modes, for example, a Rayleigh-Lam mode is a mechanical wave perpendicular to the direction of the TE mode. The waves of these lateral modes may be lost at the boundary of the resonator, resulting in energy loss of the resonator and ultimately a decrease in a Q value of the resonator. In order to suppress the leakage of acoustic waves of the lateral mode at the edge of the resonator, an additional structure that may be a protruding portion on the edge of a top electrode is generally provided at the edge of the top electrode of the resonator, to confine the acoustic waves of the lateral mode within an effective region of the resonator to increase the Q value. However, when the resonator is working, the additional structure is connected to the top electrode. Accordingly, when a voltage is applied to the top electrode and a bottom electrode of the resonator, in addition to generating primary resonance under the piezoelectric effect of a piezoelectric material, a main body portion of the resonator also generates, in the additional structure, secondary resonance having a different frequency from that of the primary resonance, thereby affecting the performance of the filter in a corresponding frequency band, as shown in Fig. 1A. In the figure, Rm represents the secondary resonance, and SW1 represents the parasitic modes. The greater the peak heights of the parasitic modes are, the greater the loss is, and the greater the negative effects on the performance of the resonator and the filter are.

### SUMMARY

The present disclosure is provided to alleviate or solve the above problems, and to effectively suppress the generation of clutters while improving a Q value of a resonator.

According to one aspect of embodiments of the present disclosure, a bulk acoustic wave resonator is provided and includes a substrate, an acoustic lens, a bottom electrode, a top electrode, and a piezoelectric layer. The top electrode is provided with a gap portion at an edge portion thereof. A gap is formed between the gap portion and the piezoelectric layer in a thickness direction of the resonator, and at least part of the gap is provided with a non-conductive insertion layer.

Optionally, at least part of the non-conductive insertion layer has a thickness that is the same as a height of a corresponding portion of the gap. Optionally, the gap has the same height, and the thickness of the non-conductive insertion layer is the same as the height of the gap, or the thickness of the non-conductive insertion layer is less than the height of the gap. Optionally, the gap is a stepped gap, and the corresponding portion of the non-conductive insertion layer is spaced apart from the gap portion in the thickness direction of the resonator. Optionally, the non-conductive insertion layer is located on an inner side portion of the stepped gap.

Optionally, a filling material layer is further provided between the insertion layer and the piezoelectric layer. Optionally, the material of the filling material layer is the same as that of the top electrode.

Optionally, the non-conductive insertion layer has a width greater than a width of the gap.

Optionally, the non-conductive insertion layer has a width less than a width of the gap. Further, the resonator further includes a blocking structure connected between the gap portion and the piezoelectric layer, and the non-conductive insertion layer is arranged between the blocking structure and the top electrode in a lateral direction. Optionally, the blocking structure and the gap portion are formed into an integral structure. Optionally, the gap is a stepped gap, the non-conductive insertion layer is spaced apart from the gas portion or the piezoelectric layer in the thickness direction of the resonator, and the non-conductive insertion layer is located on an inner side portion of the stepped gap. Alternatively, the gap is a stepped gap, the non-conductive insertion layer is connected to the top electrode and the piezoelectric layer in the thickness direction of the resonator, and the non-conductive insertion layer is located on an inner side portion of the stepped gap.

Optionally, the gap is an annular gap, and the insertion layer is an annular layer.

Optionally, the non-conductive insertion layer is made of a material that is at least one of silicon dioxide, polycrystalline silicon, borophosphate glass, metal oxide, silicon nitride, or silicon carbide.

Optionally, in a radial direction, a radial gap is formed at an inner side of an overlapping region of the non-conductive insertion layer and the top electrode in a top view of the resonator, and is arranged between the non-conductive insertion layer and the top electrode.

Optionally, an overlapping region of the non-conductive insertion layer and the top electrode in a top view of the resonator has a width greater than 2 µm, and further may be greater than 5 µm.

According to another aspect of the embodiments of the present disclosure, a filter is provided and includes the above resonator.

According to yet another aspect of the embodiments of the present disclosure, an electronic device is provided and includes the above resonator or the above filter.

### BRIEF DESCRIPTION OF DRAWINGS

The following description and drawings can help understand these and other features and advantages in various embodiments of the present disclosure. The same reference signs in the drawings always indicate the same components, wherein:
Fig. 1A is a schematic diagram of a frequency section of generating secondary resonance and a parasitic mode in a resonator;
   A curve A in Fig. 1B schematically shows a relationship between a width of an overlapping section of a gap portion at an edge of a top electrode and a parallel resonance impedance (Rₚ) value of the resonator, a curve B schematically shows a relationship between the width of the overlapping section and a secondary resonance intensity caused by the overlapping section, and a curve C schematically shows a relationship between the width of the overlapping section and the secondary resonance intensity caused by the overlapping section, after the overlapping section is isolated from a piezoelectric layer by a non-conducive insertion layer;
Fig. 2 is a schematic top view of a bulk acoustic wave resonator according to an exemplary embodiment of the present disclosure;
Fig. 2A is a schematic sectional view along line B-B in Fig. 2 according to an exemplary embodiment of the present disclosure;
Fig. 2B is a schematic sectional view along line B-B in Fig. 2 according to another exemplary embodiment of the present disclosure;
Fig. 3A is a schematic sectional view of a bulk acoustic wave resonator according to another exemplary embodiment of the present disclosure, a sectional position of which is similar to that in Fig. 2B;
Fig. 3B is a schematic sectional view of a bulk acoustic wave resonator according to an exemplary embodiment of the present disclosure, a section of which is perpendicular to the line B-B in Fig. 2;
Fig. 4 is a schematic sectional view of a bulk acoustic wave resonator according to yet another exemplary embodiment of the present disclosure, a sectional position of which is similar to that in Fig. 2B;
Fig. 5 is a schematic sectional view of a bulk acoustic wave resonator according to still another exemplary embodiment of the present disclosure, a sectional position of which is similar to that in Fig. 2B;
Fig. 6 is a schematic sectional view of a bulk acoustic wave resonator according to still another exemplary embodiment of the present disclosure, a sectional position of which is similar to that in Fig. 2B;
Fig. 7 schematically shows a relationship between a width of each structure and an Rₚ value of a resonator in three cases where a wing structure is provided at an edge of a top electrode, a protruding structure is provided at the edge of the top electrode, and an overlapping structure of a non-conductive insertion layer is provided below a gap portion of the top electrode;
Fig. 8 schematically shows a frequency-impedance curve of a resonator, in which a parallel resonant frequency f_{P} and a series resonant frequency fs of the resonator are shown;
Fig. 9 schematically shows a real part of a frequency-impedance curve of a resonator, wherein Qsw1 represents an average Q value of the resonator within 60 MHz below the series resonator frequency, and Qsw2 represents the average Q value of the resonator within a range of 60 MHz to 250 MHz below the series resonant frequency; and
Fig. 10 and Fig. 11 are respectively curve graphs of Qsw1 and Qsw2 with the width of the overlapping section of the gap portion of the top electrode in the embodiment of Fig. 5.

### DESCRIPTION OF EMBODIMENTS

The technical solutions of the present disclosure will be further described in detail below through embodiments and in conjunction with the drawings. In the specification, the same or similar reference signs refer to the same or similar components. The following description of the embodiments of the present disclosure with reference to the drawings is intended to explain the general inventive concept of the present disclosure, and should not be construed as limitation to the present disclosure.

A curve A in Fig. 1B schematically shows a relationship between a width of an overlapping section of a gap portion at an edge of a top electrode and an Rₚ value of the resonator. A curve B schematically shows a relationship between the width of the overlapping section and a secondary resonance intensity caused by the overlapping section. A curve C schematically shows a relationship between the width of the overlapping section and the secondary resonance intensity caused by the overlapping section, after the overlapping section is isolated from a piezoelectric layer by a non-conducive insertion layer.

As can be seen from the curve A, the Rₚ value of the resonator increases with the increase in the width of the overlapping section. That is, the greater the width of the overlapping section is, the greater the Rₚ value is. As can be seen from the curve B, the greater the width of the overlapping section is, the greater the secondary resonance intensity in the overlapping section is. As can be seen from the curve C, after the overlapping section is isolated from the piezoelectric layer by the non-conducive insertion layer, the secondary resonance in the overlapping section is substantially eliminated.

Therefore, in the present disclosure, acoustic waves of a lateral mode at the edge of the resonator are confined within an effective region by changing the structure of the edge of the top electrode of the resonator. Accordingly, a Q value of the resonator is further improved, and a secondary resonance effect brought by the gap portion can be eliminated or reduced. Meanwhile, an effective electromechanical coupling coefficient is not affected by the overlapping section, thereby improving the performance of the resonator.

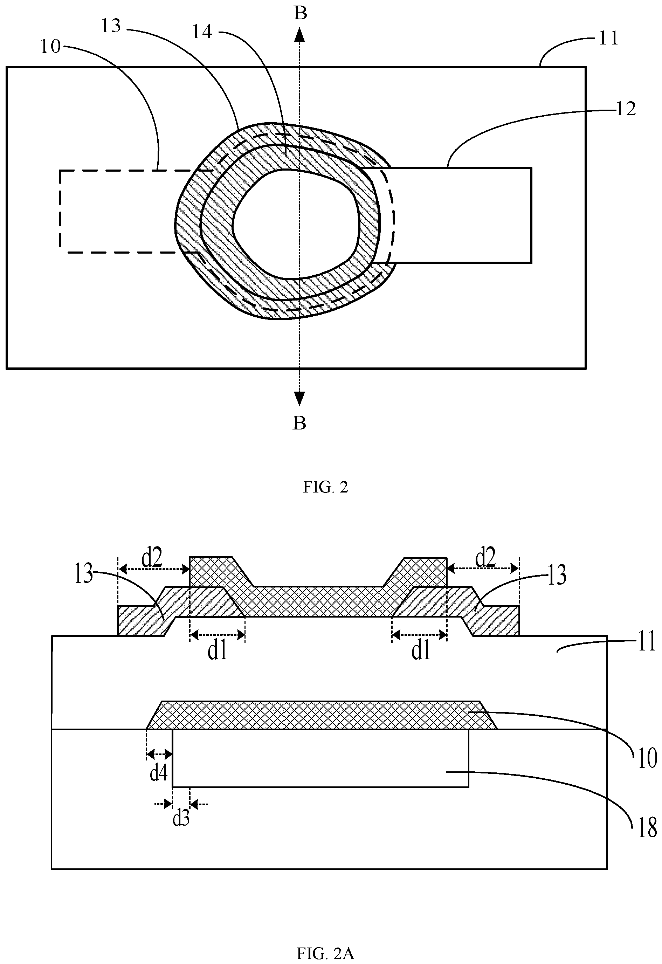

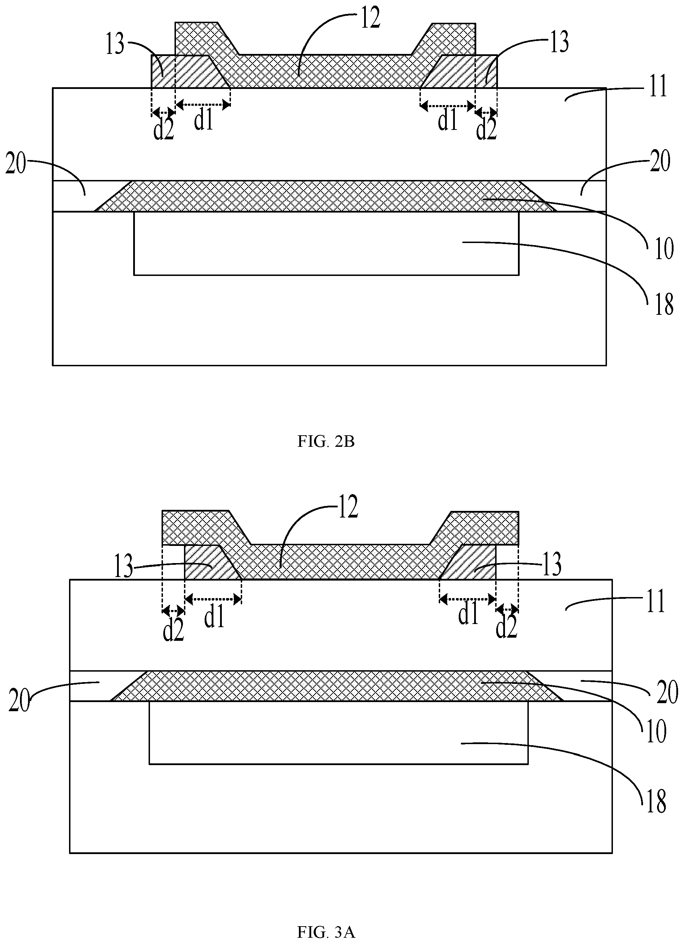

In the present disclosure, the gap portion of the top electrode is a portion of the top electrode where there is a gap (filled or not) between the top electrode and the piezoelectric layer. The overlapping section is a section of the gap portion overlapping with the insertion layer in the thickness direction of the resonator. For example, in Fig. 2A, the portion of the top electrode indicated by d1 is the gap portion and is also the overlapping section. In another embodiment, in Fig. 3A, the portions of the top electrode indicated by d1 and d2 are the gap portions, and the portion of the top electrode indicated by d1 is the overlapping section.

Fig. 2 is a schematic top view of a bulk acoustic wave resonator according to an exemplary embodiment of the present disclosure. In the embodiment shown in Fig. 2, it is a top view of a film bulk acoustic resonator. 10 represents a bottom electrode of the resonator, and the bottom electrode includes an electrode connection structure thereof. 11 represents a piezoelectric layer of the resonator. 12 represents a top electrode of the resonator, and the top electrode includes an electrode connection structure thereof. 13 represents an insertion layer located below the top electrode, and the insertion layer is partially located below the top electrode. 14 represents a portion of the insertion layer located below the top electrode.

Fig. 2A is a schematic sectional view along line B-B in Fig. 2 according to an exemplary embodiment of the present disclosure. In the embodiment shown in Fig. 2A, 18 represents an acoustic lens structure of the resonator, which may be a cavity structure etched in a substrate or a cavity structure protruding upwards, or may be acoustic wave reflection forms such as a Bragg reflection structure. The acoustic lens structure is a cavity structure etched in the substrate in Fig. 2A. 10 represents a bottom electrode. 11 represents a piezoelectric layer. 12 represents a top electrode.

In the present embodiment, the acoustic lens 18, the bottom electrode 10, the piezoelectric layer 11 and the top electrode 12 overlap with each other to form an overlapping region, which is an effective region of the resonator. The top electrode is located inside the acoustic lens, a distance between an edge of the top electrode and an edge of the acoustic lens is d3, and d3 is in a range of 0-10 µm. A distance between an end portion of the bottom electrode and the acoustic lens is d4, and d4 is in a range of 0-10 µm. 13 represents an insertion layer, the insertion layer has a first end (an inner end) and a second end (an outer end). In the present disclosure, for all components, an inner side is a side close to a center of the effective region in a radial direction or lateral direction, and an outer side is a side away from the center of the effective region in the radial direction or the lateral direction. The second end of the insertion layer 13 may be aligned with an outer edge of the top electrode or extend beyond the outer end of the top electrode. In the present embodiment, the second end of the insertion layer extends beyond the edge of the top electrode by a distance d2, and d2 is in a range of 0-20 µm. A distance between the first end of the insertion layer and the outer edge of the top electrode is d1, and a width of d1 is greater than 2 µm and further may be greater than 5 µm.

It should be specially noted that, in the present disclosure, for a numerical range, it may not only be an end value within a given range, but may be a mean value or midpoint value of the numerical range. In addition, in the present disclosure, the insertion layer may be annular or not, which fall within the scope of the present disclosure.

In the present disclosure, the insertion layer 13 is made of a non-conductive material, such as polycrystalline silicon, borophosphate glass, metal oxide, silicon nitride, and silicon carbide.

In Fig. 2A, the resonator has a first acoustic impedance in the effective region and a second acoustic impedance in an overlapping region of the insertion layer and the top electrode in a vertical direction of the resonator. Since the second acoustic impedance in the overlapping region does not match the first acoustic impedance, the transmission of acoustic waves is discontinuous at a boundary. In this way, a part of acoustic energy is coupled and reflected into the effective region at the boundary, and is converted into a piston acoustic wave mode perpendicular to the surface of the piezoelectric layer, so that the Q value of the resonator is increased.

Meanwhile, in the present embodiment, the edge portion of the top electrode is isolated from the piezoelectric layer by the insertion layer. On one hand, the electric field intensity in a part of the piezoelectric layer 11 covered by the overlapping region of the insertion layer and the top electrode in the thickness direction is weakened. On the other hand, it is equivalent to connecting a dielectric capacitor in series to a secondary resonator, such that the effective electromechanical coupling coefficient of the secondary resonator is reduced, which is embodied in a great decrease in the secondary resonance intensity. Further, since the edge portion of the top electrode is isolated from the piezoelectric layer by the insertion layer, the negative effects of the overlapping region of the insertion layer and the top electrode in the thickness direction on the electromechanical coupling coefficient of the primary resonance of the resonator is greatly reduced.

It should be noted that the insertion layer 13 shall be made of a non-conductive material to achieve the above functions and effects. If the insertion layer is made of a conductive material, although the Q value of the resonator is increased, since the electric field intensity in a part of the piezoelectric layer 11 covered by the overlapping region of the insertion layer and the top electrode in the thickness direction is not weakened, the intensity of a parasitic mode and the intensity of the secondary resonance cannot be reduced. That is, the parasitic mode and the secondary resonance may deteriorate. Furthermore, the negative effects of the overlapping region of the insertion layer and the top electrode in the thickness direction on the electromechanical coupling coefficient of the primary resonance of the resonator cannot be reduced. That is, the effective electromechanical coupling coefficient may deteriorate.

In addition, as shown in Fig. 1B, the greater the width of the overlapping region of the insertion layer and the top electrode in the thickness direction is, the higher the Rₚ value of the resonator is. However, the parasitic mode and the secondary resonance also increase with the increase of the width thereof. With the structural design of the present embodiment, the edge portion of the top electrode is spaced apart from the piezoelectric layer by the non-conductive insertion layer such that the intensities of the parasitic mode and the secondary resonance are greatly reduced. In this way, a protruding feature with a large width may be employed. Accordingly, the Rₚ value is greatly improved to reduce the secondary resonance and the parasitic mode and facilitate to improve the performance of the filter in an entire frequency band. Therefore, it is advantageous that the width of the overlapping section is greater than 2 µm, and further may be greater than 5 µm.

Fig. 2B is a schematic sectional view of a bulk acoustic wave resonator according to another exemplary embodiment of the present disclosure, and a sectional position of which is similar to that in Fig. 2A. The structure of the resonator shown in Fig. 2B is similar to the structure of the embodiment shown in Fig. 2B, both of which include a film layer structure and the insertion layer of the resonator, and are different merely in that edge portions on both sides of the bottom electrode in Fig. 2B are provided with a flat layer 20. The flat layer 20 can avoid problems such as film layer breakage and poor growth quality of the piezoelectric layer caused by factors such as rough edges of the bottom electrode and sudden changes, thereby facilitating to improve the electrical performance and stability of the resonator. Accordingly, as shown in Fig. 2B, the insertion layer 13 is flat.

Fig. 3A is a schematic sectional view of a bulk acoustic wave resonator according to another exemplary embodiment of the present disclosure, and a sectional position of which is similar to that in Fig. 2B. The structure of the resonator shown in Fig. 3A is similar to the structure of the embodiment shown in Fig. 2B, both of which include the film layer structure and the insertion layer of the resonator, and are different merely in that the positions of the insertion layers are different. In the present embodiment, a second end of the insertion layer 13 is located within an outer edge of the top electrode. The distance between the second end of the insertion layer and the outer edge of the top electrode is d2 that has a value generally in a range of 1 µm to 2 µm, so as to form an air gap. Since the acoustic impedance in the air is nearly zero, the acoustic waves in the resonator is further confined within the effective region thereof. The distance between the first end and the second end of the insertion layer, i.e. a width of the insertion layer, is d1. A value of d1 is greater than 2 µm, and further may be greater than 5 µm.

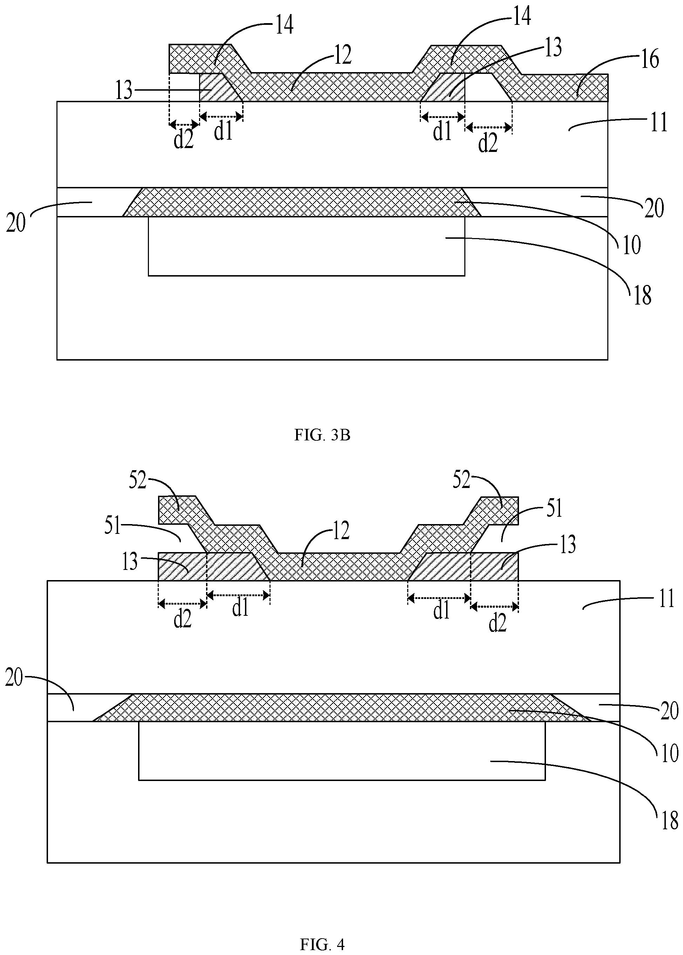

Fig. 3B is a schematic sectional view of a bulk acoustic wave resonator according to another exemplary embodiment of the present disclosure, a sectional position of which is similar to that in Fig. 2, but the sectional direction is orientated along a section perpendicular to B-B. The structure of the resonator shown in Fig. 3B is similar to the structure of the embodiment shown in Fig. 3A, both of which include the film layer structure and the insertion layer of the resonator, and are different merely in that a closed air gap structure is formed at an electrode connection portion of the top electrode.

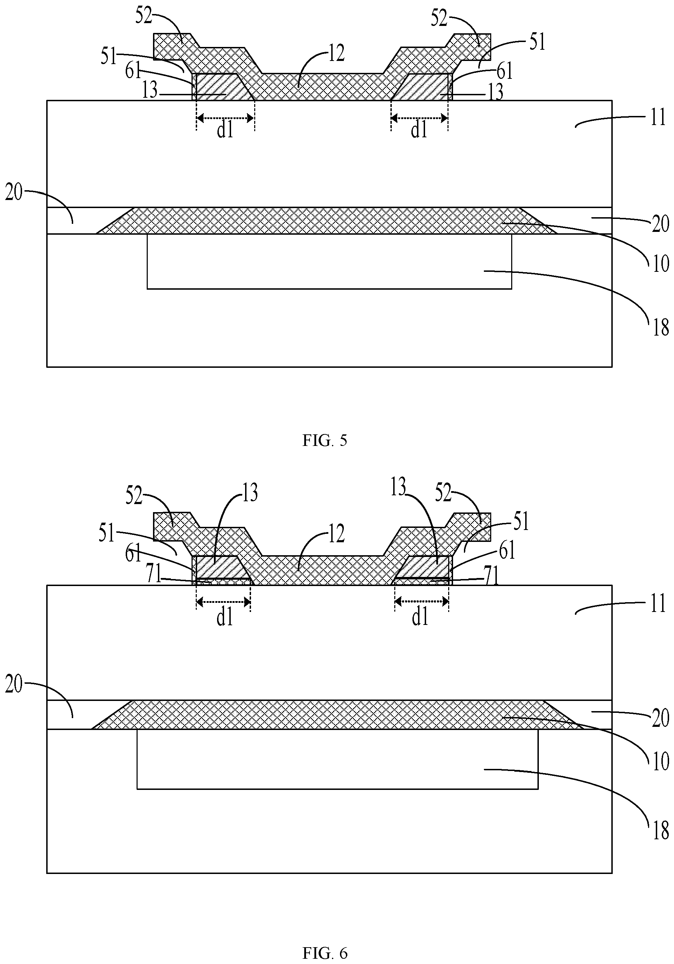

As shown in Figs. 2A, 2B, 3A and 3B, the gap has the same height, and a thickness of the non-conductive insertion layer is the same as the height of the gap. It should be noted that the "same height" herein contains a situation where there are height changes at ends of the gap due to a manufacturing process, and portions of the gap other than the ends have the same height. However, the present disclosure is not limited to thereto. As shown in Figs. 5 and 6, the gap is a stepped gap. In the present disclosure, the stepped gap not only includes a gap formed by two gap portions that have different heights and are spaced apart from each other ( for example, the embodiment shown in Fig. 6), but also includes two gap portions that have different heights and are not separated from each other (for example, the embodiment in Fig. 5). In another embodiment, the gaps have the same height, but the thickness of the insertion layer is less than the height of the gap. In yet another embodiment, the thickness of the insertion layer is variable, and the insertion layer may have a stepped structure corresponding to the structure of the stepped gap, which all fall within the scope of the present disclosure.

In the embodiments of Figs. 2, 2A, 2B, 3A and 3B, the insertion layer 13 has an annular structure. However, the present disclosure is not limited to thereto, as long as along at least part of the effective region, there is a gap between the piezoelectric layer and a top side of the edge portion of the top electrode in the thickness direction of the resonator, and the insertion layer of a non-conductive dielectric material is provided in at least a portion of the gap, which all fall within the scope of the present disclosure.

Fig. 4 is a schematic sectional view of a bulk acoustic wave resonator according to yet another exemplary embodiment of the present disclosure, and a sectional position of which is similar to that in Fig. 2B. In Fig. 4, 18 represents an acoustic lens structure of the resonator, which may be a cavity structure etched in the substrate or a cavity structure protruding upwardly, or may be acoustic wave reflection forms such as a Bragg reflection structure. The acoustic lens structure is a cavity structure etched in the substrate in Fig. 4. 10 represents a bottom electrode of the resonator, 11 represents a piezoelectric layer of the resonator, and 12 represents a top electrode of the resonator. 13 represents an insertion layer that has a second end aligned with an edge of the top electrode. In the thickness direction of the resonator, a region where the insertion layer is connected to the top electrode and overlaps each other has the same width d1, and the value of d1 is greater than 2 µm and may be further greater than 5 µm. Another portion of the insertion layer is spaced apart from the top electrode through an air gap 51. The another portion of the insertion layer has a width d2, and the value of d2 is generally in a range of 1 µm to 2 µm. An electrode portion located above the air gap 51 forms a wing structure 52, and can further confine acoustic waves in the resonator within the effective region because the acoustic impedance of the wing structure does not match the acoustic impedance in the effective region of the resonator.

As can be seen from Fig. 4, a corresponding part or a part of the insertion layer 13 is spaced apart from the gap portion in the thickness direction of the resonator.

In Fig. 4, the insertion layer 13 extends across the entire width of the gap. However, the present disclosure is not limited thereto. The insertion layer 13 may be arranged only on an inner side portion of the stepped gap, or may be arranged only on a part of the width of the gap, which all fall within the scope of the present disclosure.

Fig. 5 is a schematic sectional view of a bulk acoustic wave resonator according to still another exemplary embodiment of the present disclosure, and a sectional position of which is similar to that in Fig. 2B. The structure of the resonator shown in Fig. 5 is similar to the structure of the embodiment shown in Fig. 4, both of which include the film layer structure and the wing structure of the resonator.

The structure of the resonator shown in Fig. 5 is different from the structure of the embodiment shown in Fig. 4 in that a second end of a non-conductive insertion layer 13 is located on an inner side of an edge of a top electrode, and an air gap 51 is formed between the second end of the insertion layer and the edge of the top electrode. The air gap has a width generally in a range of 1 µm to 2 µm, and a height of the air gap is greater than a thickness of the insertion layer. Awing structure 52 is formed above the air gap 51.

Further, an etching blocking structure 61 is provided in Fig. 5, and has a relatively narrow width. A typical thickness of the etching blocking structure may be in a range of 5 Å to 100 Å, and the etching blocking structure is made of a material same as or different from that of the top electrode. The etching blocking structure 61 is provided so that the insertion layer 13 is not affected during an etching process of forming the air gap under the wing structure. In the present embodiment, the acoustic impedance of the wing structure 52 does not match the acoustic impedance in the effective region of the resonator, such that the acoustic waves in the resonator is further confined within the effective region thereof.

As shown in Fig. 5, the width of the insertion layer 13 is less than that of the gap.

It should be noted that, in the present disclosure, the width of the gap is a width of the entire gap formed between the piezoelectric layer and the edge portion of the top electrode or a sum of widths of the gaps in a case that there is not provided an insertion layer. For example, in Fig. 2A and Fig. 2B, the width of the gap is d1, and in Fig. 3A, Fig. 3B and Fig. 4, the width of the gap is a sum of d1 and d2.

In Fig. 5, the blocking structure 61 is connected between the gap portion and the piezoelectric layer, and the insertion layer 13 is provided between the blocking structure 61 and the top electrode in the lateral direction. The blocking structure 61 may be an integral structure with the gap portion.

As shown in Fig. 5, the gap is a stepped gap. The insertion layer 13 is connected to the top electrode and the piezoelectric layer 11 in the thickness direction of the resonator, and is located on the inner side portion of the stepped gap.

Fig. 6 is a schematic sectional view of a bulk acoustic wave resonator according to still another exemplary embodiment of the present disclosure, and a sectional position of which is similar to that in Fig. 2B. The structure of the resonator shown in Fig. 6 is similar to the structure of the embodiment shown in Fig. 5, both of which include the film layer structure and the wing structure of the resonator. The structure of the resonator shown in Fig. 6 is different from the structure of the embodiment shown in Fig. 5 in that another etching blocking structure 71 is provided between the non-conductive insertion layer 13 and the piezoelectric layer 11 and arranged below the non-conductive insertion layer 13. The another etching blocking structure 71 has a relatively narrow width, and a typical thickness of the another etching blocking structure may be in a range of 5 Å to 100 Å. The another etching blocking structure is made of a material same as or different from that of the top electrode. When the piezoelectric layer is made of aluminum nitride, the air gap has a filling layer that is made of silicon dioxide. In a process of releasing the air gap, that is, in a process of etching the dioxide with hydrofluoric acid, the hydrofluoric acid passes through the aluminum nitride to damage the insertion layer. Therefore, in the present embodiment, due to the presence of the etching blocking structures 61 and 71, the insertion layer 13 is not affected during the etching process of forming the air gap below the top electrode.

As shown in Fig. 6, the gap is a stepped gap, the insertion layer 13 is spaced apart from the piezoelectric layer 11 in the thickness direction of the resonator through the blocking structure 71, which is used as a filling material layer, and the insertion layer 13 is located on the inner side portion of the stepped gap. However, the present disclosure is not limited thereto. For example, in Fig. 6, the blocking structure 71 may be provided above the insertion layer 13 and the insertion layer is directly connected to the piezoelectric layer, which all fall within the scope of the present disclosure.

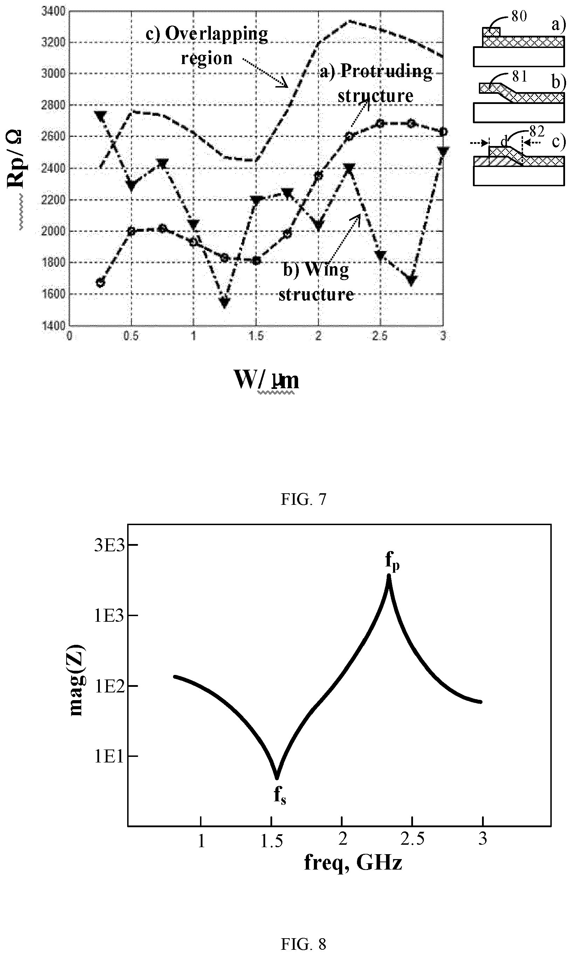

Fig. 7 schematically shows a simulation result diagram of a relationship among the widths of the protruding structure, the width of the wing structure, the width of the overlapping section and the Rₚ of the resonator, wherein an additional structure (which may be the protruding structure on the edge of the top electrode) is shown by 80 in a schematic diagram a) in a top right corner of Fig. 7, the wing structure is shown by 81 in a schematic diagram b) in the top right corner of Fig. 7, and the overlapping region between the non-conductive insertion layer structure (the height of which is 100 Å) and the top electrode in the thickness direction of the resonator is a region d (the overlapping section) in a schematic diagram c) in the top right corner of Fig. 7. As can be seen from Fig. 7, if the top electrode is spaced apart from the piezoelectric layer through the insertion layer, the Rₚ value is the maximum, followed by the case where the edge of the top electrode is provided with the protruding structure, and the Rₚ value is the minimum in the case where the wing structure is provided. It may be observed from the above relationship that when a width W of the overlapping region (i.e., the overlapping section) increases, the Rₚ value gradually increases. Therefore, when the top electrode is spaced apart from the piezoelectric layer through the non-conductive insertion layer and the width of the overlapping section is increased at the same time, the Rₚ value of the resonator can be increased to the greatest extent.

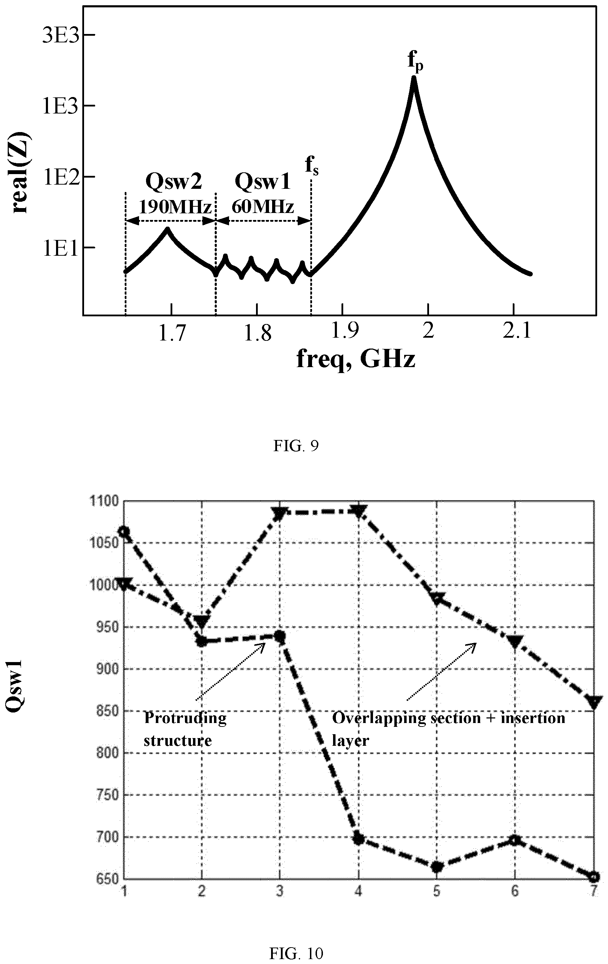

Fig. 8 schematically shows a frequency-impedance curve of the resonator, in which a parallel resonant frequency f_{P} and a series resonant frequency fs of the resonator are shown. A distance between the parallel resonant frequency and the series resonant frequency is the electromechanical coupling coefficient of the resonator. Fig. 9 schematically shows a real part of the frequency-impedance curve of the resonator, wherein Qsw1 represents an average Q value of the resonator within 60 MHz below the series resonator frequency, and Qsw2 represents an average Q value of the resonator within 60 MHz to 250 MHz below the series resonant frequency. Changes of the Q value of the resonator in Qsw1 and Qsw2 respectively represent the intensities of the parasitic mode and the secondary resonance in the resonator. The higher the Q value is, the lower the intensity is. The greater the Qsw1 and Qsw2 are, the less the clutter or secondary resonance intensity of the resonator within a corresponding frequency range is.

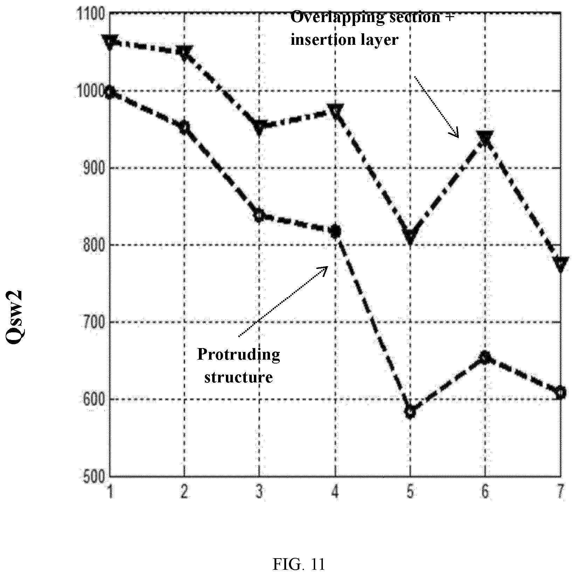

Fig. 10 and Fig. 11 are respectively curve graphs of Qsw1 and Qsw2 with the width of the protruding structure in the embodiment of Fig. 5. As can be seen from Fig. 10 and Fig. 11, when the top electrode is spaced apart from the piezoelectric layer through the non-conductive insertion layer and the width W of the overlapping section is greater than 2 µm, the Q value is higher than that in the case where an additional structure that may be the protruding structure arranged on the edge of the top electrode is directly located above the top electrode, indicating that the secondary resonance in the resonator is suppressed and the resulting clutters are reduced. Accordingly, when the top electrode is spaced apart from the piezoelectric layer through the non-conductive insertion layer, the secondary resonance in the resonator is effectively reduced. At the same time, the Q value in the resonator is greatly increased by increasing the width of the overlapping section.

In the present disclosure, the electrode may be made of a material such as gold (Au), tungsten (W), molybdenum (Mo), platinum (Pt), ruthenium (Ru), iridium (Ir), titanium tungsten (TiW), aluminum (Al), and titanium (Ti).

The piezoelectric layer may be made of a material such as aluminum nitride (AlN), doped aluminum nitride, zinc oxide (ZnO), lead zirconate titanate (PZT), lithium niobate (LiNbO₃), quartz, potassium niobate (KNbO₃) or lithium tantalate (LiTaO₃), as well as doped materials with the compounds as main components.

The non-conductive insertion layer may be made of a material such as silicon dioxide (Si02), polycrystalline silicon, borophosphate glass (BSG), metal oxide (such as, TeO(x)), silicon nitride, or silicon carbide.

Based on the above description, the present disclosure provides the following technical solutions.
1. A bulk acoustic wave resonator includes:
   a substrate;
   an acoustic lens;
   a bottom electrode;
   a top electrode; and
   a piezoelectric layer,
   wherein
   an edge portion of the top electrode is provided with a gap portion, a gap is formed between the gap portion and the piezoelectric layer in a thickness direction of the resonator, and a non-conductive insertion layer is provided in at least part of the gap.

Further, the gap is an annular gap, and the insertion layer is an annular layer. The insertion layer may be a silicon dioxide layer.

An overlapping region of the insertion layer and the top electrode in a top view of the resonator has a width that is greater than 2 µm and further may be greater than 5 µm.

2. A filter includes the above resonator.

3. An electronic device includes the above resonator or the above filter. It should be noted that the electronic device herein includes, but is not limited to, intermediate products such as radio frequency front-ends and filter amplification modules, and terminal products such as mobile phones, WIFI and an unmanned aerial vehicles.

Although the embodiments of the present disclosure have been shown and described, it will be understood by those skilled in the art that changes can be made to these embodiments without departing from the principles and spirit of the present disclosure, and the scope of the present disclosure is determined by the appended claims and their equivalents.

## Claims

1. A bulk acoustic wave resonator, comprising:
a substrate;
an acoustic lens;
a bottom electrode;
a top electrode having a gap portion arranged at an edge portion thereof; and
a piezoelectric layer,
wherein a gap is formed between the gap portion and the piezoelectric layer in a thickness direction of the resonator, and at least part of the gap is provided with a non-conductive insertion layer therein.

2. The resonator according to claim 1, wherein at least part of the non-conductive insertion layer has a thickness that is the same as a height of a corresponding portion of the gap.

3. The resonator according to claim 2, wherein the gap has the same height, and the thickness of the non-conductive insertion layer is the same as the height of the gap; or
the thickness of the non-conductive insertion layer is less than the height of the gap.

4. The resonator according to claim 2, wherein the gap is a stepped gap, and the corresponding portion of the non-conductive insertion layer is spaced apart from the gap portion in the thickness direction of the resonator.

5. The resonator according to claim 4, wherein the non-conductive insertion layer is located on an inner side portion of the stepped gap.

6. The resonator according to claim 1, further comprising:
an etching blocking layer provided between the non-conductive insertion layer and the piezoelectric layer.

7. The resonator according to claim 6, wherein the etching blocking layer is made of a material same as a material of the top electrode.

8. The resonator according to claim 1, wherein the non-conductive insertion layer has a width greater than a width of the gap.

9. The resonator according to claim 1, wherein the non-conductive insertion layer has a width less than a width of the gap.

10. The resonator according to claim 9, further comprising:
a blocking structure connected between the gap portion and the piezoelectric layer, the non-conductive insertion layer being arranged between the blocking structure and the top electrode in a lateral direction.

11. The resonator according to claim 10, wherein the blocking structure and the gap portion are formed into an integral structure.

12. The resonator according to claim 10, wherein the gap is a stepped gap, the non-conductive insertion layer is spaced apart from the piezoelectric layer or the top electrode in the thickness direction of the resonator, and the non-conductive insertion layer is located on an inner side portion of the stepped gap; or
the gap is a stepped gap, the non-conductive insertion layer is connected to the top electrode and the piezoelectric layer in the thickness direction of the resonator, and the non-conductive insertion layer is located on an inner side portion of the stepped gap.

13. The resonator according to claim 1, wherein the gap is an annular gap, and the non-conductive insertion layer is an annular layer.

14. The resonator according to claim 1, wherein the non-conductive insertion layer is made of a material that is at least one of silicon dioxide, polycrystalline silicon, borophosphate glass, metal oxide, silicon nitride, or silicon carbide.

15. The resonator according to claim 1, wherein in a radial direction, a radial gap is formed at an inner side of an overlapping region of the non-conductive insertion layer and the top electrode in a top view of the resonator, and is arranged between the non-conductive insertion layer and the top electrode.

16. The resonator according to any one of claims 1-15, wherein an overlapping region of the non-conductive insertion layer and the top electrode in a top view of the resonator has a width greater than 2 µm.

17. The resonator according to claim 16, wherein the width of the overlapping region is greater than 5 µm.

18. A filter, comprising the bulk acoustic wave resonator according to any one of claims 1-17.

19. An electronic device, comprising the bulk acoustic wave resonator according to any one of claims 1-17 or the filter according to claim 18.
